# EUROPEAN PATENT APPLICATION

(11) **EP 4 564 440 A1**
(43) Date of publication of application: **04.06.2025**
(21) Application number: 24159745.9
(22) Date of filing: 26.02.2024
(51) Int. Cl.: H01L 31/0687, H01L 31/078

(54) **TANDEM CELL AND PHOTOVOLTAIC MODULE**

(30) Priority: 30.11.2023 CN 202311641878
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: ZHANG, Yuanfang, Haining, 314416 (CN); JIN, Hao, Haining, 314416 (CN); XU, Menglei, Haining, 314416 (CN); YANG, Jie, Haining, 314416 (CN); ZHANG, Xinyu, Haining, 314416 (CN)
(74) Representative: Balder IP Law, S.L.

(57) **Abstract**

Embodiments of the present disclosure relate to the technical field of photovoltaic technologies, and provide a tandem cell and a photovoltaic module. The tandem cell includes: a bottom cell, including: a substrate having a front surface and a back surface that are opposite to each other, and a semiconductor layer disposed on the back surface of the substrate and is doped with doping ions, where doping concentration of doping ions in a part of the semiconductor layer close to the substrate is less than doping concentration of doping ions in a part of the semiconductor layer away from the substrate; an intermediate layer disposed on a side surface of the semiconductor layer away from the substrate; and a top cell disposed on a side of the intermediate layer away from the substrate. In this way, performance of the tandem cell may be at least improved.

## Description

### TECHNICAL FIELD

Embodiments of the present disclosure relate to the field of photovoltaic technologies, and more specifically to a tandem cell and a photovoltaic module.

### BACKGROUND

At present, with gradual depletion of fossil energy, solar cells are being increasingly used as a new energy alternative. The solar cell is a device that converts light energy from the sun into electrical energy. The solar cells generate carriers based on the photovoltaic principle, and the carriers are then led out using electrodes to facilitate efficient use of electrical energy.

Conventional solar cells mainly include single junction cells, such as interdigitated back contact (IBC) cells, tunnel oxide passivated contact (TOPCon) cells, passivated emitter and real cell (PERC), heterojunction with Intrinsic Thin layer (HIT/HJT) cells, and perovskite cells. Optical losses and photo-generated carrier recombination at the surface and in the bulk of the silicon substrate can be reduced by arrangements and functional definition of different film layers, such that the photoelectric conversion efficiency of the solar cells is improved.

It has been found that the perovskite cells have the property of tunable band gaps to achieve translucency, which means that low-energy photons are capable of passing through the perovskite cell. That is, a photovoltaic cell may be disposed under the perovskite cell to breakthrough the limit of efficiency of the single junction cell by "stacking/laminating," i.e., to obtain tandem cells. The principle of the tandem cell is as follows. A top cell with a wider band gap absorbs high-energy photons, a bottom cell with a narrower band gap improves photon utilization, and the top cell and the bottom cell cooperate with each other to break the theoretical efficiency limit of the single junction cell and improve the conversion efficiency. However, the cell performance of the tandem cell prepared still needs to be improved.

### SUMMARY

Embodiments of the present disclosure provide a tandem cell and a photovoltaic module, which at least improve performance of the tandem cell.

According to one aspect of the embodiments of the present disclosure, a tandem cell is provided. The tandem cell includes a bottom cell. The bottom cell includes a substrate having a front surface and a back surface that are opposite to each other, and a semiconductor layer disposed on the back surface of the substrate and is doped with doping ions, where doping concentration of the doping ions in a first part of the semiconductor layer close to the substrate is less than doping concentration of the doping ions in a second part of the semiconductor layer further away from the substrate than the first part. The tandem cell further includes an intermediate layer disposed on a side surface of the semiconductor layer away from the substrate; and a top cell disposed on a side of the intermediate layer away from the substrate.

In some embodiments, the doping concentration of the doping ions in the semiconductor layer gradually increases in a direction perpendicular to the back surface of the substrate and away from the substrate.

In some embodiments, the semiconductor layer includes a plurality of semiconductor films that are successively stacked in a direction perpendicular to the back surface of the substrate, the plurality of semiconductor films including at least a first semiconductor film and a second semiconductor film, the first semiconductor film being adjacent to the second semiconductor film and closer to the substrate than the second semiconductor film, and doping concentration of the second semiconductor film is greater than doping concentration of the first semiconductor film.

In some embodiments, the semiconductor layer includes a first semiconductor film and a second semiconductor film stacked on a side of the first semiconductor film away from the substrate, and the second semiconductor film has a thickness larger than or equal to a thickness of the first semiconductor film.

In some embodiments, the first semiconductor film has the thickness in a range of 5 nm to 120 nm, and the second semiconductor film has the thickness in a range of 5 nm to 100 nm.

In some embodiments, the semiconductor layer has a total thickness in a range of 10 nm to 120 nm.

In some embodiments, doping concentration of doping ions in the semiconductor layer at a surface of the semiconductor layer away from the substrate is in a range of 1×10¹⁹ cm³ to 1×10²¹ cm³.

In some embodiments, a material of the intermediate layer includes inorganic oxide.

In some embodiments, the intermediate layer has a thickness in a range of 1 nm to 20 nm.

In some embodiments, the top cell at least one of a perovskite thin-film solar cell, a copper indium gallium selenide thin-film solar cell, a cadmium telluride thin-film solar cell, an amorphous silicon thin-film solar cell, and a group III to V thin-film solar cell.

In some embodiments, doping concentration of doping ions in the semiconductor layer at a surface of the semiconductor layer close to the substrate is in the range of 1×10¹⁹ cm³ to 5×10²⁰ cm³.

In some embodiments, the semiconductor layer includes a third semiconductor film and a fourth semiconductor film stacked on a side of the third semiconductor film away from the substrate, where a doping type of the third semiconductor film is different from a doping type of the fourth semiconductor film.

In some embodiments, the fourth semiconductor film has doping concentration in a range of 1×10¹⁸ cm³ to 1×10²¹ cm³.

In some embodiments, the fourth semiconductor film has a thickness in the range of 1 nm to 20 nm.

According to another aspect of the embodiments of the present disclosure, a photovoltaic module is further provided. The photovoltaic module includes: a plurality of cell strings, where each of the plurality of cell strings includes a plurality of tandem cells described in any embodiment of the disclosure that are electrically connected; at least one encapsulation layer, where each encapsulation layer is configured to cover a surface of a corresponding cell string; and at least one cover plate, where each cover plate is configured to cover a surface of a corresponding encapsulation layer away from the plurality of cell strings.

### BRIEF DESCRIPTION OF THE DRAWINGS

One or more embodiments are illustrated by illustrations with reference to the corresponding drawings which do not constitute a limitation of the embodiments and the figures in the drawings do not constitute a limitation of scale unless specifically stated. In order to more clearly explain the technical solutions of the embodiments of the present disclosure or in the related technologies, the drawings required to be used in the embodiments will be briefly described below. It will be obvious that the drawings described below are only some embodiments of the present disclosure, and other drawings can be obtained from these drawings without creative effort for those of ordinary skill in the art.
FIG. 1 is a schematic structural diagram of a tandem cell according to embodiments of the present disclosure.
FIG. 2 is a schematic structural diagram of a tandem cell according to other embodiments of the present disclosure.
FIG. 3 is a schematic structural diagram of a tandem cell according to other embodiments of the present disclosure.
FIG. 4 is a schematic structural diagram of a tandem cell according to other embodiments of the present disclosure.
FIG. 5 is a schematic structural diagram of a tandem cell according to other embodiments of the present disclosure.
FIG. 6 is a schematic structural diagram of a tandem cell according to other embodiments of the present disclosure.
FIG. 7 is a schematic structural diagram of a tandem cell according to other embodiments of the present disclosure.
FIG. 8 is a schematic structural diagram of a tandem cell according to other embodiments of the present disclosure.
FIG. 9 is a schematic structural diagram of a photovoltaic module according to embodiments of the present disclosure.

### DETAILED DESCRIPTION

As can be seen from the background section, the cell performance of the conventional tandem cells still needs to be improved.

According to one aspect of some embodiments of the present disclosure, a tandem cell is provided. The tandem cell includes a bottom cell, a top cell, and an intermediate layer disposed between the top cell and the bottom cell. The bottom cell includes a substrate and a semiconductor layer, where the substrate has a front surface and a back surface that are opposite to each other, and the semiconductor layer is disposed on the back surface of the substrate and is doped with doping ions. Doping concentration of doping ions in a part of the semiconductor layer close to the substrate is less than doping concentration of the doping ions in another part of the semiconductor layer away from the substrate. The intermediate layer is disposed on a side surface of the semiconductor layer away from the substrate. When the part of the semiconductor layer with a larger doping concentration and away from the substrate serves as a passivation layer of the bottom cell, the intermediate layer can serve as a recombination layer of the tandem cell. In this case, the semiconductor layer with non-uniform doping concentration may improve electrical performance and passivation performance of the tandem cell. When the part of the semiconductor layer with a larger doping concentration and away from the substrate serves as a recombination layer of the tandem cell, since a surface of the semiconductor layer is hydrophobic and fails to effectively support deposition of the top cell, the intermediate layer may not serve as the composition layer of the tandem cell but serves as a hydrophilic film layer covered on the surface of the semiconductor layer. Increasing wettability between the top cell and the bottom cell may enable that the top cell and the bottom cell are successfully stacked or laminated. In this case, there is no need to provide a TCO recombination layer in the tandem cell, which can effectively reduce parasitic absorption in the tandem cell, thereby improving photoelectric conversion efficiency of the tandem cell and performance of the tandem cell.

To make the objectives, technical solutions, and advantages of embodiments of the present disclosure clearer, the embodiments of the present disclosure are described in detail with reference to accompanying drawings. However, persons of ordinary skill in the art may understand, in the embodiments of the present disclosure, more technical details are provided for readers to better understand the present disclosure. However, even without these technical details and various variations and modifications based on the embodiments hereinafter, the technical solutions of the present disclosure may also be practiced.

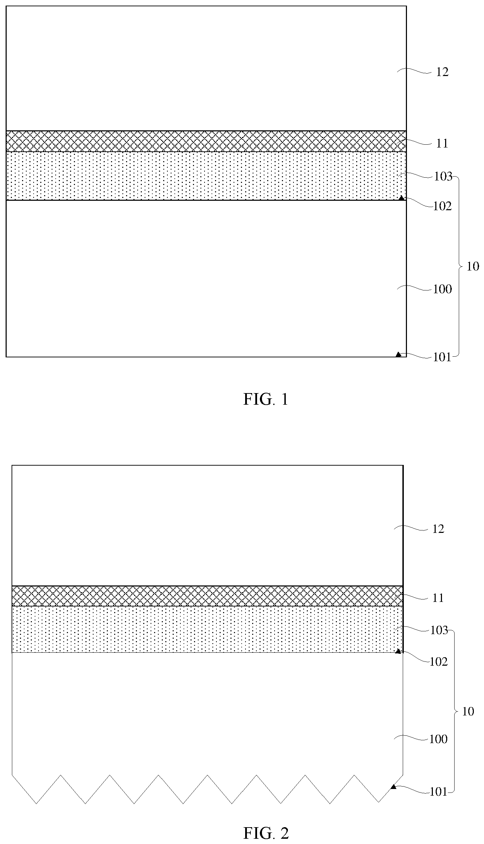

FIG. 1 is a schematic structural diagram of a tandem cell according to embodiments of the present disclosure.

Embodiments of the present disclosure provide a tandem cell. Referring to FIG. 1, the tandem cell is illustrated. The tandem cell includes a bottom cell 10. The bottom cell 10 includes a substrate 100 having a front surface 101 and a back surface 102 that are opposite to each other, and a semiconductor layer 103 disposed over the back surface 102 of the substrate 100. The semiconductor layer 103 is doped with doping ions (dopant), where doping concentration of doping ions in a first part of the semiconductor layer 103 close to the substrate 100 is less than doping concentration of doping ions in a second part of the semiconductor layer 103 further away from the substrate 100 than the first part. The tandem cell further includes an intermediate layer 11 disposed on a side surface of the semiconductor layer 103 facing away from the substrate 100, and a top cell 12 disposed over a side of the intermediate layer 11 facing away from the substrate 100.

In a tandem cell in the existing technologies, the semiconductor layer disposed on the back surface of the bottom cell has uniform doping concentration, and the semiconductor layer merely serves as a passivation structure for the bottom cell in the tandem cell. In order to ensure interface characteristics between the top cell and the bottom cell of the tandem cell, it is necessary to arrange a transparent conductive oxide (TCO) coated glass recombination layer between the bottom cell and the top cell. Electrons and holes of the top and bottom cells are recombined in the recombination layer to ensure consistency of currents of the top and bottom cells. However, such a recombination layer made of TCO material has a large parasitic absorption problem, which may affect a photoelectric conversion efficiency of the tandem cell.

In the embodiments of the present disclosure, the doping concentration in the semiconductor layer 103 disposed on the back surface of the bottom cell 10 has a gradient (i.e., the semiconductor layer 103 has the non-uniform doping concentration). That is, the doping concentration of the doping ions in the part of the semiconductor layer 103 close to the substrate 100 is less than that of the doping ions in the other part of the semiconductor layer 103 away from the substrate 100. Therefore, the part of the semiconductor layer 103 close to the substrate 100 and having the smaller doping concentration may serve as a passivation structure of the bottom cell 10, and the other part of the semiconductor layer 103 away from the substrate 100 and having the larger doping concentration can serve as the passivation structure on the back surface of the bottom cell 10, and can replace a TCO recombination layer to serve as a recombination layer of the tandem cell due to meeting the requirement of a composition layer of the tandem cell. When the part of the semiconductor layer 103 away from the substrate 100 and having the larger doping concentration serves as the passivation structure on the back surface of the bottom cell 10, the intermediate layer 11 can still serve as the recombination layer of the tandem cell. In this case, the semiconductor layer 103 with the non-uniform doping concentration can improve electrical performance and passivation performance of the tandem cell. When the part of the semiconductor layer 103 away from the substrate 100 and having the larger doping concentration serves as the recombination layer of the tandem cell, since a surface of the semiconductor layer 103 is hydrophobic and is not capable of effectively supporting deposition of the top cell 12, the intermediate layer 11 may not serve as the composition layer of the tandem cell but serves as a hydrophilic film layer covered on the surface of the semiconductor layer 103. With aid of the intermediate layer 11, wettability between the top cell 12 and the bottom cell 10 may be increased, such that the top cell 12 and the bottom cell 10 are smoothly stacked or laminated. In this case, there is no need to provide a TCO recombination layer in the tandem cell, such that parasitic absorption in the tandem cell is effectively reduced, thereby improving photoelectric conversion efficiency of the tandem cell and improving performance of the tandem cell.

In some embodiments, the bottom cell 10 may be a tunnel oxide passivated contact (TOPCon) cell.

In some embodiments, the substrate 100 may be made of an elemental semiconductor material. Specifically, the elemental semiconductor material is formed of a single element, for example, silicon or germanium. The elemental semiconductor material may be in a monocrystalline state, a polycrystalline state, an amorphous state, or a microcrystalline (i.e., a state having both the monocrystalline state and the amorphous state). For example, silicon may be at least one of monocrystalline silicon, polycrystalline silicon, amorphous silicon, or microcrystalline silicon.

In some embodiments, the substrate 100 may also be made of a compound semiconductor material. The common compound semiconductor materials include, but are not limited to, silicon germanium, silicon carbide, gallium arsenide, indium gallide, perovskite, cadmium telluride, copper indium selenium, or other materials. The substrate 100 may be a sapphire substrate, a silicon-on-insulator substrate, or a germanium-on-insulator substrate.

In some embodiments, the substrate 100 may be an N-type semiconductor substrate 100 or a P-type semiconductor substrate 100. The N-type semiconductor substrate 100 is doped with a doping element of an N-type (N-type doping element), and the N-type doping element may be any one of Group-V elements, such as a phosphorus (P) element, a bismuth (Bi) element, an antimony (Sb) element, and an arsenic (As) element. The P-type semiconductor substrate 100 is doped with a doping element of a P-type (P-type doping element), and the P-type doping element may be any one of Group-III elements, such as a boron (B) element, an aluminum (Al) element, a gallium (Ga) element, and an indium (In) element.

FIG. 2 is a schematic structural diagram of a tandem cell according to embodiments of the present disclosure.

Referring to FIG. 2, in some embodiments, textured processing may be conducted on the front surface of the substrate 100. In this way, the surface of the substrate 100 may have an uneven textured structure, which may effectively reduce reflection of sunlight on the surface of the silicon substrate, and improve absorbance of sunlight on the surface of the silicon substrate, thereby enhancing photoelectric conversion efficiency.

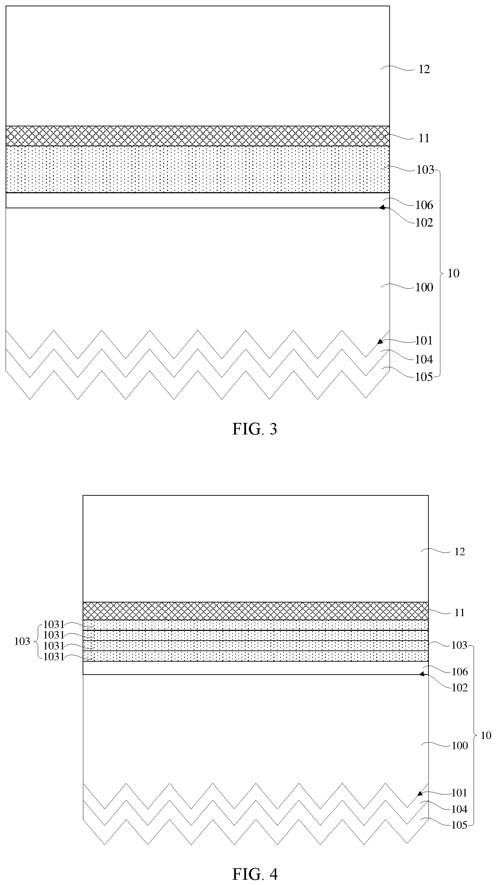

FIG. 3 is a schematic structural diagram of a tandem cell according to embodiments of the present disclosure.

Referring to FIG. 3, in some embodiments, the bottom cell 10 further includes an emitter 104 on the front surface of the substrate 100 and a passivation layer 105 on a side surface of the emitter 104 away from the substrate 100. A shape of each of the emitter 104 and the passivation layer 105 may follow a shape of the textured structure on the front surface 101 of the substrate 100. Specifically, if the front surface 101 of the substrate 100 has a textured structure, the emitter 104 and the passivation layer 105 may also have a textured structure. It is to be noted that the emitter 104 has a doping element, and a doping type of the doping element in the emitter 104 is different from a doping type of the doping element in the substrate 100. If the substrate 100 is an N-type substrate, the doping type of the doping element in the emitter 104 is a P type. If the substrate 100 is a P-type substrate, the doping type of the doping element in the emitter 104 is an N type.

In some embodiments, a material of the passivation layer 105 may include silicon nitride or aluminum oxide. By arranging the passivation layer on the front surface 101 of the substrate 100, a passivation effect of the solar cell may be further improved.

Still referring to FIG. 3, in some embodiments, a tunnel dielectric layer 106 may also be disposed on the back surface 102 of the substrate 100. The tunnel dielectric layer 106 may be disposed between the back surface 102 of the substrate 100 and the semiconductor layer 103. The tunnel dielectric layer 106 achieves an effect of chemical passivation. Since an interface state defect is present between an interface between the substrate 100 and the tunnel dielectric layer 106, the back surface 102 of the substrate 100 has a larger interface state density. Such an increase of the interface state density may promote recombination of photo-generated carriers, and increase a fill factor, a short-circuit current, and an open-circuit voltage of the solar cell. In this way, the photoelectric conversion efficiency of the solar cell may be improved. The tunnel dielectric layer 106 is disposed on the surface of the substrate 100, such that the tunnel dielectric layer 106 may have a chemical passivation effect on the surface of the substrate 100. Specifically, a recombination rate of the carriers may be reduced by saturating dangling bonds of the substrate, reducing a defect state density of the substrate 100, and reducing a recombination center of the substrate 100.

In some embodiments, a material of the tunnel dielectric layer 106 may include at least one of silicon oxide, silicon nitride, silicon oxynitride, silicon carbide, or magnesium fluoride.

It is to be noted that the doping type of the doping element in the semiconductor layer 103 is the same as that of the doping element in the substrate 100. For example, if the doping type of the doping element in the substrate 100 is a P type, the doping type of the doping element in the semiconductor layer 103 is also a P type. Alternatively, if the doping type of the doping element in the substrate 100 is an N type, the doping type of the doping element in the semiconductor layer 103 is also an N type.

The doping concentration of the doping element (doping ions) in the semiconductor layer 103 is larger than the doping concentration of the doping element in the substrate 100 to form a sufficiently high potential barrier on the back surface 102 of the substrate 100, such that majority carriers in the substrate 100 may travel through the tunnel dielectric layer 106 into the semiconductor layer 103.

In some embodiments, the part of the semiconductor layer 103 close to the substrate 100 and having the smaller doping concentration may act as a doping conductive structure in the bottom cell 10. In some embodiments, the part of the semiconductor layer 103 away from the substrate 100 and having the larger doping concentration may also act as a doping conductive structure in the bottom cell 10 to achieve a doping and conductive effect.

In some embodiments, the semiconductor layer 103 is capable of forming energy band bending on the surface of the substrate 100, and the tunnel dielectric layer 106 causes an energy band on the surface of the substrate 100 to an asymmetrical shift, such that a potential barrier for majority carriers in the carriers is lower than a potential barrier for minority carriers in the carriers. Therefore, the majority carriers are capable of easily traveling through the tunnel dielectric layer 106 for quantum tunneling, while the minority carriers are difficult to travel through the tunnel dielectric layer 106, such that selective transport of the carriers can be achieved.

The semiconductor layer 103 achieves a field passivation effect. Specifically, an electrostatic field directed to the interior of the substrate 100 is formed on the surface of the substrate 100, such that the minority carriers escape from the interface, and thus concentration of the minority carriers is reduced. In this way, a carrier recombination rate at the interface of the substrate 100 may be reduced, such that the fill factor, the short-circuit current, and the open-circuit voltage of the solar cell may be increased, thereby improving the photoelectric conversion efficiency of solar cell.

A material of the semiconductor layer 103 may include at least one of amorphous silicon, polycrystalline silicon, or silicon nitride.

In some embodiments, in a direction perpendicular to the back surface 102 of the substrate 100 and away from the substrate 100, the doping concentration of the doping ions in the semiconductor layer 103 is gradually increased.

That is, for any position (e.g., second position) of the semiconductor layer 103, if a distance between the second position and the back surface 102 of the substrate 100 is larger than a distance between a current position (e.g., first position) and the back surface 102 of the substrate 100, doping concentration of doping ions at the second position in the semiconductor layer 103 is larger than doping concentration of doping ions at the first position in the semiconductor layer 103. If the distance between the second position and the back surface 102 of the substrate 100 is less than the distance between the first position and the back surface 102 of the substrate 100, the doping concentration of doping ions at the second position in the semiconductor layer 103 is less than the doping concentration of doping ions at the first position in the semiconductor layer 103.

The semiconductor layer 103 with the gradually increased doping concentration of the doping ions in the direction perpendicular to the back surface 102 of the substrate 100 and away from the substrate 100 is formed as follows. An undoped intrinsic semiconductor layer is formed, and then ion injecting is performed on the intrinsic semiconductor layer on a side of the intrinsic semiconductor layer away from the substrate 100 and in the direction perpendicular to the back surface 102 of the substrate 100. With aid of the injection of the ions, doping concentration in a region, close to an outer side and facing away from the substrate 100, of the formed semiconductor layer 103 is larger, and doping concentration in a region, close to an inner side and facing the substrate 100 is smaller. In this way, passivation performance and electrical performance of the tandem cell can be improved.

FIG. 4 is a schematic structural diagram of a tandem cell according to embodiments of the present disclosure.

Referring to FIG. 4, in some embodiments, the semiconductor layer 103 may include a plurality of semiconductor films 1031 that are successively laminated. In the direction perpendicular to the back surface 102 of the substrate 100 and away from the substrate 100, doping concentrations of doping ions in adjacent semiconductor films 1031 are gradually increased.

That is, for any semiconductor film 1031 in the semiconductor layer 103, doping concentration of the semiconductor film 1031 is less than doping concentration of another semiconductor film 1031 disposed on a side of the semiconductor film 1031 facing away from the substrate 100, and the doping concentration of the semiconductor film 1031 is larger than doping concentration of another semiconductor film 1031 disposed on a side of the semiconductor film 1031 close to the substrate 100.

The semiconductor layer 103 with a plurality of semiconductor films of different doping concentrations successively laminated on the back surface 102 of the substrate 100 is formed as follows. An intrinsic semiconductor film is formed and doping processing is performed on the intrinsic semiconductor film to form a semiconductor film 1031. A next intrinsic semiconductor film is formed on a side of the previous semiconductor film 1031 facing away from the substrate 100 and doping processing is performed on the next intrinsic semiconductor film to form a next semiconductor film 1031, where doping concentration of the next semiconductor film 1031 is larger than that of the previous semiconductor film 1031. In a similar manner, the entire semiconductor layer 103 is formed. Alternatively, in-situ doping may be directly performed during forming of the semiconductor film 1031, such that the semiconductor film 1031 has doping ions. As such, the plurality of successively laminated semiconductor films 1031 form the semiconductor layer 103, and the doping concentration of a semiconductor film 1031 further away from the substrate 100 is larger than the doping concentration of a semiconductor film 1031 closer to the substrate 100. Therefore, the semiconductor layer 103 can achieve the function of a doping conductive structure on the back surface 102 of the bottom cell 10, and the part of the semiconductor layer 103 on a side close to the top cell 12 reaches doping concentration level of a degenerate semiconductor. In this way, the part of the semiconductor layer 103 on the side close to the top cell 12 satisfies the requirements of serving as the recombination layer of the tandem cell, such that the conventional TCO recombination layer can be omitted, parasitic absorption of the cell can be reduced, and photoelectric conversion efficiency of the tandem cell can be improved.

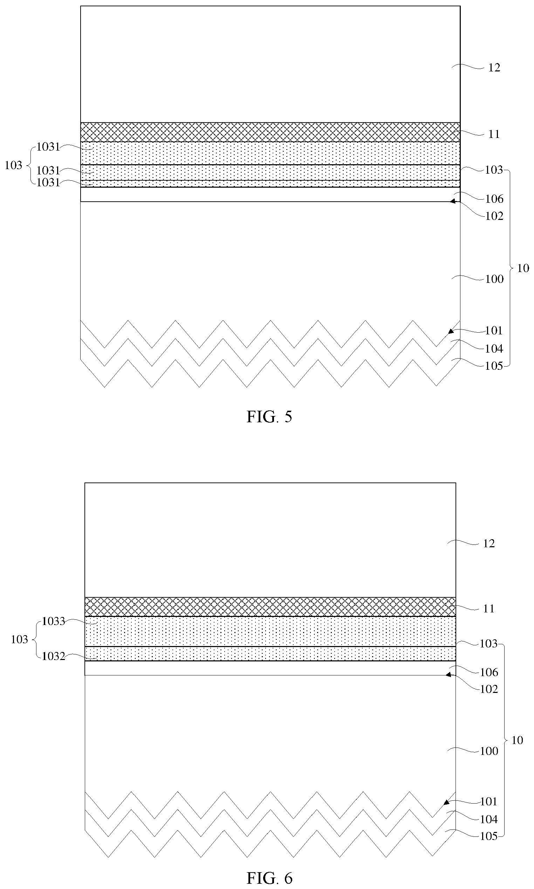

FIG. 5 is a schematic structural diagram of a tandem cell according to embodiments of the present disclosure.

Referring to FIG. 4 to FIG. 5, in some embodiments, in the direction perpendicular to the back surface 102 of the substrate 100 and away from the substrate 100, adjacent semiconductor films 1031 may have a same thickness or gradually increased thicknesses.

Referring to FIG. 4, in the direction perpendicular to the back surface 102 of the substrate 100 and away from the substrate 100, the adjacent semiconductor films 1031 may have the same thickness. Referring to FIG. 5, in the direction perpendicular to the back surface 102 of the substrate 100 and away from the substrate 100, thicknesses of the adjacent semiconductor films 1031 are gradually increased.

That is, for any semiconductor film 1031, a thickness of an adjacent semiconductor film 1031 disposed on a side of the semiconductor film 1031 away from the substrate 100 is larger than or equal to a thickness of the semiconductor film 1031. In such configured semiconductor films 1031, the semiconductor film 1031 having a larger doping concentration and disposed at a position further away from the substrate 100 has a larger thickness, and the semiconductor film 1031 having a smaller doping concentration and disposed at a position closer to the substrate 100 has a smaller thickness. Regardless of whether each of the semiconductor films 1031 has the smaller doping concentration or has the larger doping concentration, the semiconductor films 1031 are all can capable of achieving an effect of the doping conductive structure on the back surface 102 of the bottom cell 10, and merely the semiconductor film 1031 having the larger doping concentration is capable of achieving the effect of the recombination layer between the bottom cell 10 and the top cell 12.

Therefore, when the semiconductor film 1031, disposed on a side away from the substrate 100, having the larger doping concentration also has a larger thickness, the semiconductor film 1031 is capable of ensuring the interface characteristics between the bottom cell 10 and the top cell 12 in place of the TCO recombination layer while ensuring that the bottom cell has a properly functioned doping conductive structure. In this way, the TCO recombination layer in the tandem cell can be omitted, parasitic absorption can be reduced, and efficiency of the cell can be improved.

FIG. 6 is a schematic structural diagram of a tandem cell according to embodiments of the present disclosure.

Referring to FIG. 6, in some embodiments, in the direction perpendicular to the surface of the substrate 100 and away from the substrate 100, the semiconductor layer 103 may include a first semiconductor film 1032 and a second semiconductor film 1033 that are successively stacked.

In some embodiments, a thickness of the second semiconductor film 1033 may be larger than or equal to a thickness of the first semiconductor film 1032. As illustrated in FIG. 6, the thickness of the second semiconductor film 1033 is larger than the thickness of the first semiconductor film 1032.

The first semiconductor film 1032 has smaller doping concentration, and can function as a doping conductive structure in the bottom cell 10 in the tandem cell. The second semiconductor film 1033 has a larger doping concentration, and can satisfy the requirement of serving as a recombination layer of the tandem cell when the second semiconductor film 1033 reaches the doping concentration level of the degenerate semiconductor. In this case, the traditional TCO recombination layer can be omitted, such that parasitic absorption of the cell can be reduced, and photoelectric conversion efficiency of the cell can be improved.

In addition, the second semiconductor film 1033 can also function as the doping conductive structure on the back surface of the bottom cell 10, but the first semiconductor film 1032 fails to serve as a recombination layer between the bottom cell 10 and the top cell 12. Therefore, by defining the thickness of the second semiconductor film 1033 to be larger than the thickness of the first semiconductor film 1032, the semiconductor layer 103 is ensured to better replace the TCO recombination layer on the premise that the bottom cell 10 has a property functioned doping conductive structure. Compared with the solution in which the semiconductor layer 103 includes the laminated plurality of semiconductor films 1031 and the solution in which the semiconductor layer 103 has gradually changing doping concentrations, in the solution in which the semiconductor layer 103 merely includes the first semiconductor film 1032 and the second semiconductor film 1033, the semiconductor layer 103 can better replace the composition layer, process operations and the structure of the tandem cell are simplified, and the manufacture efficiency can be improved.

In some embodiments, the first semiconductor film 1032 has a thickness in a range of 5 nm to 120 nm, and the second semiconductor film 1033 has a thickness in a range of 1 nm to 100 nm.

If the thickness of the first semiconductor film 1032 is too small, the region in the semiconductor layer 103 and having the larger doping concentration is relatively wide, which may result in waste. If the thickness of the first semiconductor film 1032 is too large, the thickness of the second semiconductor film 1033 in the semiconductor layer 103 is too small, which may result in poor effect when the second semiconductor film 1033 replaces the recombination layer.

Therefore, the thickness of the first semiconductor film 1032 needs to be set within a suitable range. When the thickness of the first semiconductor film 1032 is in the range of 5 nm to 120 nm, for example, the thickness of the first semiconductor film 1032 may be 5 nm, 10 nm, 50 nm, 100 nm, 120 nm, or the like, the second semiconductor film 1033 can effectively achieve the effect of the recombination layer, and unnecessary waste can be avoided.

If the thickness of the second semiconductor film 1033 is too small, the second semiconductor film 1033 may not effectively replace the recombination layer. If the thickness of the second semiconductor film 1033 is too large, the first semiconductor film 1032 in the semiconductor layer 103 may be too narrow, which results in some waste.

Therefore, the thickness of the second semiconductor film 1033 needs to be set within a suitable range. When the thickness of the second semiconductor film 1033 is in the range of 1 nm to 100 nm, for example, the thickness of the second semiconductor film 1033 may be 1 nm, 5 nm, 10 nm, 30 nm, 50 nm, 80 nm, 100 nm, or the like, the second semiconductor film 1033 can effectively achieve the effect of the recombination layer, and unnecessary waste can be avoided.

In some embodiments, the semiconductor layer 103 may have a total thickness in the range of 10 nm to 120 nm.

If the total thickness of the semiconductor layer 103 is too large, there may have some redundant thicknesses when the semiconductor layer 103 achieves the effect of serving as a doping conductive structure of the bottom cell 10 and serving as a recombination layer between the bottom cell 10 and the top cell 12, such that the thickness of the tandem cell may be increased and some waste may be caused. If the total thickness of the semiconductor layer 103 is too small, it may be difficult for the semiconductor layer 103 to simultaneously serve as the doping conductive structure of the bottom cell 10 and serve as the recombination layer between the bottom cell 10 and the top cell 12.

Therefore, the total thickness of the semiconductor layer 103 needs to be set within the suitable range. The total thickness of the semiconductor layer 103 is in the range of 10 nm to 120 nm, for example, the total thickness of the semiconductor layer 103 may be 10 nm, 20 nm, 40 nm, 60 nm, 70 nm, 91 nm, 112 nm, 120 nm, or the like, the semiconductor layer 103 is capable of simultaneously serving as a doping conductive structure of the bottom cell 10 and serving as the recombination layer between the top cell 12 and the bottom cell 10, and avoiding occurrence of thickness redundancy of the semiconductor layer 103, reducing the thickness of the tandem cell, and reducing waste.

In some embodiments, doping concentration of doping ions in the semiconductor layer at a surface of the semiconductor layer 103 away from the substrate 100 may be in a range of 1×10¹⁹ cm³ to 1×10²¹ cm³.

If the doping concentration of the doping ions in the semiconductor layer at the surface of the semiconductor layer 103 away from the substrate 100 is too low, the semiconductor layer 103 may be hard to reach a doping concentration level of the degenerate semiconductor, and is insufficient to serve as a recombination layer of the tandem cell. In this case, the intermediate layer 11 needs to serve as a recombination layer of the tandem cell, which may increase parasitic absorption of the cell and affect the photoelectric conversion efficiency of the cell. Otherwise, if the doping concentration of the doping ions in the semiconductor layer at the surface of the semiconductor layer 103 away from the substrate 100 is too high, waste may be caused.

Therefore, the doping concentration of the doping ions in the semiconductor layer at the surface of the semiconductor layer 103 away from the substrate 100 needs to be set within a suitable range. When the doping concentration of the doping ions in the semiconductor layer at the surface, away from the substrate 100, of the semiconductor layer 103 ranges from 1×10¹⁹ cm³ to 1×10²¹ cm³, for example, the doping concentration of the doping ions in the semiconductor layer at the surface of the semiconductor layer 103 away from the substrate 100 may be 1×10¹⁹ cm³, 1×10²⁰ cm³, 1×10²¹ cm³, or the like. In this way, the semiconductor layer 103 can replace a recombination layer of the tandem cell, the intermediate layer does not need to be used as the recombination layer, and there is also no need to provide a TCO layer between the top cell 12 and the bottom cell 10, thereby reducing parasitic absorption of the tandem cell and improving the photoelectric conversion efficiency of the cell without causing waste.

In some embodiments, doping concentration of doping ions in the semiconductor layer at a surface of the semiconductor layer close to the substrate may be in the range of 1×10¹⁹ cm³ to 5×10²⁰ cm³.

If the doping concentration of the doping ions in the semiconductor layer at the surface of the semiconductor layer 103 close to the substrate 100 is too low, the semiconductor layer 103 is insufficient to serve as a doping conductive layer on the back surface of the bottom cell, which may affect the passivation performance and electrical performance of the cell. On the contrary, if the doping concentration of the doping ions in the semiconductor layer at the surface of the semiconductor layer 103 close to the substrate 100 is too high, some waste is caused.

Therefore, the doping concentration of the doping ions in the semiconductor layer at the surface, close to the substrate 100, of the semiconductor layer 103 needs to be set within a suitable range. When the doping concentration of the doping ions in the semiconductor layer at the surface of the semiconductor layer 103 close to the substrate 100 ranges from 1×10¹⁹ cm³ to 5×10²⁰ cm³, for example, the doping concentration of the doping ions in the semiconductor layer at the surface of the semiconductor layer 103 close to the substrate 100 may be 1×10¹⁹ cm³, 5×10¹⁹ cm³, 1×10²⁰ cm³, 5×10²⁰ cm³, or the like. In this way, the surface of the semiconductor layer 103 close to the substrate 100 can achieve a good doping conductive function, thereby improving the passivation performance and electrical performance of the cell without causing waste.

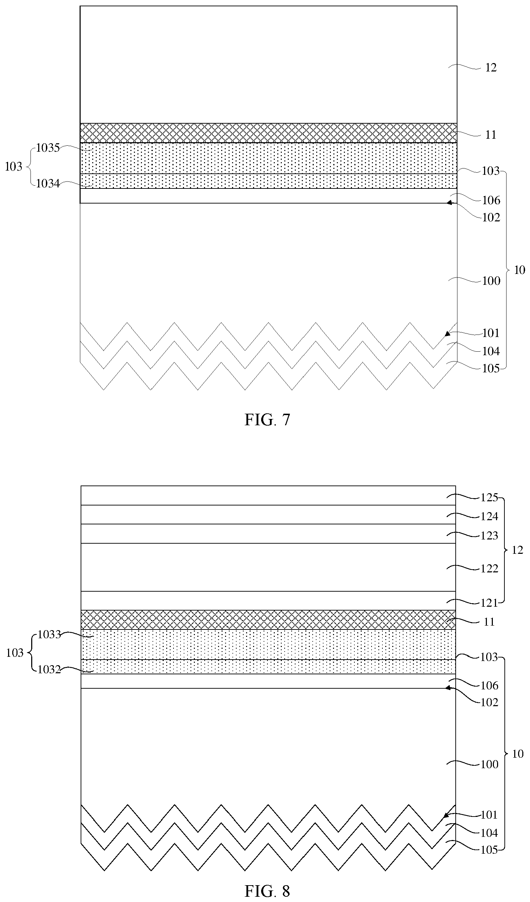

FIG. 7 is a schematic structural diagram of a tandem cell according to some embodiments of the present disclosure.

Referring to FIG. 7, in some embodiments, in the direction perpendicular to the surface of the substrate 100 and away from the substrate 100, the semiconductor layer 103 may include a third semiconductor film 1034 and a fourth semiconductor film 1035 that are successively laminated, where a doping type of the third semiconductor film 1034 is different from a doping type of the fourth semiconductor film 1035.

In some embodiments, the doping type of the third semiconductor film 1034 may be the same as the doping type of the substrate 100, and the doping type of the fourth semiconductor film 1035 may be different from the doping type of the substrate 100. When the doping type of the third semiconductor film 1034 is an N type, the doping type of the fourth semiconductor film 1035 may be a P type. When the doping type of the third semiconductor film 1034 is a P type, the doping type of the fourth semiconductor film 1035 may be an N type.

With such configurations, the third semiconductor film 1034 and the fourth semiconductor film 1035 can improve the performance of the tandem cell, and further enhance carrier transport and extraction abilities of the tandem cell. The third semiconductor film 1034 and the fourth semiconductor film 1035 which have different doping types can form trap-assisted recombination tunneling and band-band tunneling, such that the performance of the tandem cell is improved and a higher fill factor and cell efficiency can be achieved. Specifically, when doping concentration in the semiconductor layer 103 is relatively small, conduction bands of the third semiconductor film 1034 and the fourth semiconductor film 1035 are not overlapped, and therefore band-to-band tunneling may not occur. In this case, trap-assisted recombination tunneling is dominant, and a larger defect concentration contributes to the trap-assisted recombination tunneling effect, such that the cell performance can be improved. When the doping concentration in the semiconductor layer 103 is relatively large, the conduction bands of the third semiconductor film 1034 and the fourth semiconductor film 1035 are overlapped to initiate band-band tunneling, and band-band tunneling is dominant, and a higher filling factor and cell efficiency can be achieved as compared with trap-assisted recombination tunneling.

In some embodiments, the fourth semiconductor film 1035 may have doping concentration in the range of 1×10¹⁸ cm³ to 1×10²¹ cm³. For example, the doping concentration in the fourth semiconductor film 1035 may be 1×10¹⁸ cm³, 1×10¹⁹ cm³, 1×10²⁰ cm³, 1×10²¹ cm³, or the like.

If the doping concentration in the fourth semiconductor film 1035 is too low, it may be difficult for the fourth semiconductor layer 1035 to reach a doping concentration level of the degenerate semiconductor, and the fourth semiconductor layer 1035 is insufficient to serve as the recombination layer of the tandem cell. In this case, the intermediate layer 11 needs to be served as the recombination layer of the tandem cell, which may increase parasitic absorption of the cell and affect the photoelectric conversion efficiency of the cell. If the doping concentration in the fourth semiconductor film 1035 is too high, some waste is caused.

Therefore, the doping concentration in the fourth semiconductor film 1035 needs to be set within a suitable range. When the doping concentration of the fourth semiconductor film 1035 is in the range of 1×10¹⁸ cm³ to 1×10²¹ cm³, the fourth semiconductor film 1035 can replace the recombination layer of the tandem cell, the intermediate layer does not need to be used as the recombination layer, and there is also no need to provide a TCO layer between the top cell 12 and the bottom cell 10, thereby reducing parasitic absorption of the tandem cell and improving the photoelectric conversion efficiency of the cell without causing waste.

In some embodiments, the fourth semiconductor film 1035 may have a thickness in the range of 1 nm to 20 nm. For example, the thickness of the fourth semiconductor film 1035 is 1 nm, 5 nm, 10 nm, 15 nm, 20 nm, or the like.

If the thickness of the fourth semiconductor film 1035 is too small, the effect of replacing the recombination layer by the fourth semiconductor film 1035 may be poor. If the thickness of the fourth semiconductor film 1035 is too large, the third semiconductor film 1034 may be too narrow, which may lead to some waste.

Therefore, the thickness of the fourth semiconductor film 1035 needs to be set within a suitable range. When the thickness of the fourth semiconductor film 1035 is in the range of 1 nm to 20 nm, the fourth semiconductor film 1035 can effectively achieve the effect of a recombination layer and there is also no unnecessary waste.

If the doping concentration in the semiconductor layer 103 is hard to reach the doping concentration level of the degenerate semiconductor and the semiconductor layer 103 fails to serve as a recombination layer of the tandem cell 20, the intermediate layer 11 needs to be provided as the recombination layer in the tandem cell to ensure an interface effect between the bottom cell 10 and the top cell 12. In some embodiments, a material of the intermediate layer 11 may include a transparent conductive oxide (TCO), a thin-film metal layer, and a polymer conductive layer. The TCO may be indium tin oxide, aluminum-doped zinc oxide, fluorine-doped tin oxide, or antimony-doped tin oxide. In this case, although the recombination layer structure is still provided in the tandem cell, the semiconductor layer 103 having different doping concentrations and larger doping concentration at a position away from the substrate 100 can still improve passivation performance and electrical performance of the cell.

If the doping concentration in the side surface, away from the substrate 100, of the semiconductor layer 103 complies with the doping concentration level of the degenerate semiconductor, the part of the semiconductor layer 103 away from the substrate 100 can also satisfy the requirements of the recombination layer of the tandem cell, such that the intermediate layer 11 does not need to be used as the recombination layer. In this case, the semiconductor layer 103 may replace the recombination layer to ensure the interface characteristics between the bottom cell 10 and the top cell 12.

Referring to FIGS. 1 to FIG. 7, in some embodiments, a material of the intermediate layer 11 may include an inorganic oxide.

Since the surface of the semiconductor layer 103 doped with the doping ions is hydrophobic, it is difficult to effectively deposit the film layer such as the top cell 12 on the surface of the semiconductor layer 103, and thus the wettability of the surface of the semiconductor layer 103 is adjusted before forming the film layer of the top cell 12. Therefore, when the part of the semiconductor layer 103 away from the substrate 100 replace the recombination layer to ensure the interface characteristics between the bottom cell 10 and the top cell 12, the intermediate layer 11 may be made of a hydrophilic material as a hydrophilic structure to achieve high wettability between the bottom cell 10 and the top cell 12, thereby facilitating bonding between the top cell 12 and the bottom cell 10.

Therefore, the intermediate layer 11 may be made of inorganic oxide materials with hydrophilicity, such that hydrophilicity of the side surface of the semiconductor layer 103 away from the substrate 100 can be adjusted to improve the wettability of the interface between the bottom cell 10 and the top cell 12, thereby further facilitating the bonding between the top cell 10 and the bottom cell 12.

In some embodiments, the intermediate layer 11 may be formed by a physical vapor deposition (PVD) process.

In some embodiments, the intermediate layer 11 may have a thickness in the range of 1 nm to 20 nm.

If the thickness of the intermediate layer 11 is too small, the intermediate layer 11 is not sufficient to improve the hydrophilicity of the side of the semiconductor layer 103 away from the substrate 100, and the wettability of the interface between the bottom cell 10 and the top cell 12 may still be poor, which may lead to poor bonding effect between the top cell 12 and the bottom cell 10. If the thickness of the intermediate layer 11 is too large, the thickness of the tandem cell may also be too large, resulting in some waste.

Therefore, the thickness of the intermediate layer 11 needs to be set within a suitable range. The thickness of the intermediate layer 11 is in the range of 1 nm to 20 nm, for example, the thickness of the intermediate layer 11 may be 1 nm, 5 nm, 10 nm, 15 nm, 20 nm, or the like. In this case, the hydrophilicity of the side of the semiconductor layer 103 away from the substrate 100 can be improved, and the wetting effect of the interface between the bottom cell 10 and the top cell 12 can be improved, which may facilitate the bonding between the bottom cell 10 and the top cell 12. In addition, the thickness of the tandem cell may be not increased, and no unnecessary waste is caused.

In some embodiments, the top cell 12 may include a perovskite thin-film solar cell, a copper indium gallium selenide (CIGS) thin-film solar cell, a cadmium telluride (CdTe) thin-film solar cell, an amorphous silicon thin-film solar cell, or a group III-V thin-film solar cell.

The following describes the bottom cell 10 being a TOPCon cell and the top cell 12 being a perovskite solar cell as an example.

FIG. 8 is a schematic structural diagram of a tandem cell according to some embodiments of the present disclosure.

Referring to FIG. 8, the top cell 12 is disposed on the side, away from the semiconductor layer 103, of the intermediate layer 11. The top cell 12 may include a first transport layer 121, a perovskite substrate 122, a second transport layer 123, a transparent conductive layer 124, and an antireflection layer 125 that are sequentially laminated in a direction away from the substrate. The first transport layer 121 is disposed between the intermediate layer 11 and the perovskite substrate 122.

In some embodiments, the first transport layer 121 may be one of an electron transport layer and a hole transport layer, and the second transport layer 123 may be the other of the electron transport layer and the hole transport layer.

In some embodiments, the electron transport layer may be made from at least one of following materials, such as tin oxide (SnOx), titanium dioxide (TiO2), and Buckminster fullerene (C60) and its derivatives including [6,6]-phenyl-C61-butyric acid methyl ester (PCBM). The hole transport layer may be made from at least one of following materials, such as Poly[bis(4-phenyl)(2,4,6-triMethylphenyl)aMine] (PTAA), 2,2',7,7'-Tetrakis[N,N-di(4-methoxyphenyl)amino]-9,9'-spirobifluorene (spiro-OMeTAD), nickel oxide (NiOx), or cuprous thiocyanate (CuSCN).

In some embodiments, a thickness of the first transport layer 121 may be in the range of 1 nm to 1 µm in a direction perpendicular to the surface of the intermediate layer 11.

The first transport layer 121 is mainly designed to enhance the ability to collect and transport carriers of one type, and prevent the carriers of other type from transmitting to the intermediate layer 11. Therefore, if the thickness of the first transport layer 121 is too large, a transport distance of carriers migrating to the intermediate layer 11 is too large, which may cause carrier recombination, thereby leading to a large loss of carriers, and thus resulting in a decrease in the photoelectric conversion efficiency of the solar cell. If the thickness of the first transport layer 121 is too small, the first transport layer 121 may have limited capabilities for collecting and transporting carriers, such that the first transport layer 121 may be incapable of collecting and transporting all carriers of a specific type generated by the perovskite substrate 122 in time, thereby resulting in a large loss of carriers and affecting the photoelectric conversion efficiency of the solar cell. In addition, the first transport layer 121 of having small thickness may have decreased capability for isolating carriers of another type, which may result in recombination of carriers of different types, thereby further affecting the photoelectric conversion efficiency of the solar cell.

Therefore, during forming of the first transport layer 121, the thickness of the first transport layer 121 in the direction perpendicular to the surface of the intermediate layer 11 is set to be in the range of 1 nm to 1 µm, for example, 1 nm, 5 nm, 10 nm, 50 nm, 100 nm, 200 nm, 250 nm, 400 nm, 500 nm, 650 nm, 750 nm, 800 nm, 950 nm, or the like. In this way, the first transport layer 121 has sufficiently large aggregation and transport capabilities for carries of one type and has a sufficient capability for isolating carriers of another type, thereby reducing the carrier loss caused by recombination and migration of the carriers, and ensuring the photoelectric conversion efficiency of the solar cell.

Similar to the first transport layer 121, the second transport layer 123 functions to aggregate and transport carries of one type generated in the perovskite substrate. If the second transport layer 123 functions as the electron transport layer, the second transport layer 123 is configured to aggregate electrons and transport the aggregated electrons to the transparent conductive layer 124 for the electrodes to output electric energy, and is further configured to block holes from flowing directly to the transparent conductive layer 124. If the second transport layer 123 functions as the hole transport layer, the second transport layer 123 is configured to block electrons from entering the transparent conductive layer 124 and enhance the transport of holes, so as to prevent the perovskite substrate 122 from directly contacting the transparent conductive layer 124. The photoelectric conversion capability and electric energy output of the solar cell are ensured.

In some embodiments, a thickness of the second transport layer 123 may be in the range of 1 nm to 1 µm in the direction perpendicular to the surface of the intermediate layer 11.

The second transport layer 123 is mainly designed to enhance the ability to collect and transport carriers of one type, and prevent the carrier of other type from transmitting to the transparent conductive layer 124. Therefore, if the thickness of the second transport layer 123 in the direction perpendicular to the surface of the intermediate layer 11 is too large, a transport distance of carriers migrating to the transparent conductive layer 124 is too large, which ma cause carrier recombination, thereby leading to a large loss of carriers, and resulting in a decrease in the photoelectric conversion efficiency of the solar cell. If the thickness of the second transport layer 123 is too small, the second transport layer 123 may have limited capabilities for aggregating and transporting carriers, such that the second transport layer 123 may be incapable of aggregating and transporting all carriers of a specific type generated in the perovskite substrate 122 in time, thereby resulting in a large loss of carriers and affecting the photoelectric conversion efficiency of the solar cell. In addition, the second transport layer 123 of having small thickness may have decreased capability for isolating carriers of another type, which may result in recombination of carriers of different types, thereby further affecting the photoelectric conversion efficiency of the solar cell.

Therefore, during forming of the second transport layer 123, the thickness of the second transport layer 123 in the direction perpendicular to the surface of the intermediate layer 11 is set to be in the range of 1 nm to 1 µm, for example, 1 nm, 5 nm, 10 nm, 50 nm, 100 nm, 200 nm, 250 nm, 400 nm, 500 nm, 650 nm, 750 nm, 800 nm, 950 nm, or the like. In this way, the second transport layer 123 has sufficiently large aggregation and transport capabilities for carries of one type and has a sufficient capability for isolating carriers of another type, thereby reducing the carrier loss caused by recombination and migration of the carriers, and ensuring the photoelectric conversion efficiency of the solar cell.

In some embodiments, the transparent conductive layer 124 may be at least one of tin-doped indium oxide (ITO), aluminum-doped zinc oxide (AZO), fluorine-doped tin oxide (FTO), or aluminum-doped zinc oxide (ATO).

In some embodiments, the transparent conductive layer 124 may be made of a polymeric transparent material such as polydimethylsiloxane (PDMS), polymethyl methacrylate (PMMA), or the like.

In some embodiments, the antireflection layer 125 can reduce reflection of incident light, improve utilization of light by the cell, and improve the photoelectric conversion efficiency of the tandem cell. A refractive index of the antireflection layer 125 is larger than a refractive index of the crystalline silicon cell and less than a refractive index of air, and thus the refractive index of the antireflection layer 125 may be 1 to 1.5.

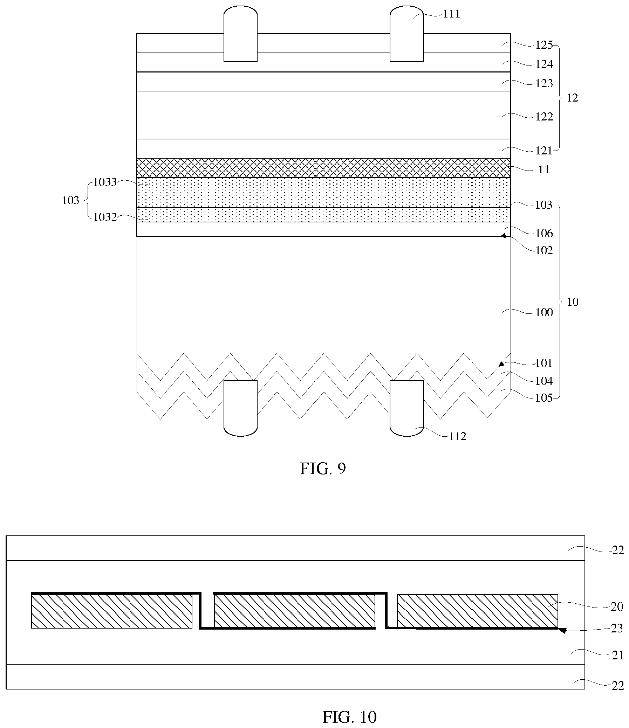

FIG. 9 is a schematic structural diagram of a tandem cell according to some embodiments of the present disclosure.

Referring to FIG. 9, in some embodiments, the tandem cell may further include bottom electrodes 112 and top electrodes 111. The bottom electrodes 112 are disposed on a side of the bottom cell 10 close to the front surface 101 of the substrate 100, and the top electrode 111 is disposed on a side of the top cell 12 away from the substrate 100. The bottom electrodes 112 are in electrical contact with the emitter 104 after penetrating the passivation layer 105, and the top electrodes 111 are in electrical contact with the transparent conductive layer 124 after penetrating the anti-reflection layer 125.

In some embodiments, the top electrodes 111 and the bottom electrodes 112 may be sintered from burn-through paste. The method for forming the top electrode 111 and the bottom electrode 112 may include: printing metal paste on a part of a surface of the passivation layer 105 or the antireflection layer 125 using a screen-printing process. The metal paste may include at least one of silver paste, aluminum paste, copper paste, tin paste, gold paste, lead paste, and nickel paste. The metal paste is subjected to a sintering process.

In some embodiments, the metal paste has a material with a highly corrosive component such as glass powder, such that in the sintering process, the corrosive component may corrode the passivation layer 105 or the antireflection layer 125, such that the metal paste may be allowed to permeate the passivation layer 105 or the antireflection layer 125.

When the passivation layer 105 includes an aluminum oxide layer, a laser grooving process may be performed followed by a screen-printing process, to ensure that bottom electrodes 112 to be in electrical contact with emitter 104.

According to some embodiments of the present disclosure, the tandem cell is provided. The tandem cell includes the bottom cell, the top cell, and the intermediate layer disposed between the top cell and the bottom cell. The bottom cell includes the substrate and the semiconductor layer, where the substrate has the front surface and the back surface that are opposite to each other, and the semiconductor layer is disposed over the back surface of the substrate and is doped with doping ions. The doping concentration of the doping ions in the part of the semiconductor layer close to the substrate is less than the doping concentration of the doping ions in the other part of the semiconductor layer away from the substrate. The intermediate layer is disposed on the side surface of the semiconductor layer away from the substrate. When the semiconductor layer merely serves as the passivation structure on the back surface of the bottom cell, the intermediate layer can serve as the recombination layer of the tandem cell. In this case, the semiconductor layer with a non-uniform doping concentration can improve electrical performance and passivation performance of the tandem cell. When the part of the semiconductor layer away from the substrate serves as the recombination layer of the tandem cell, there is no need to provide a TCO recombination layer in the tandem cell, which can effectively reduce parasitic absorption in the tandem cell, such that photoelectric conversion efficiency of the tandem cell and performance of the tandem cell can be improved.

Correspondingly, embodiments of the present disclosure further provide a photovoltaic module. Reference is now be made in detail to a photovoltaic module according to another embodiment of the present disclosure. For the part the same as or corresponding to the previous embodiment, reference may be made to the corresponding description of the previous embodiment, which is be described in detail.

FIG. 10 is a schematic structural diagram of a photovoltaic module according to embodiments of the present disclosure.

Referring to FIG. 10, the photovoltaic module includes: a plurality of cell strings, each of the plurality of cell strings includes a plurality of tandem cells 20 electrically connected with each other according to the above embodiments; at least one encapsulation layer 21, configured to cover a surface of each of the cell strings; and at least one cover plate 22, where each cover plate 22 is configured to cover a surface of a corresponding encapsulation layer 21 away from the cell strings. The tandem cells 20 are electrically connected in a whole piece or in multiple pieces to form a plurality of cell strings, and the plurality of cell strings are electrically connected in series and/or in parallel.

Specifically, in some embodiments, the plurality of cell strings may be electrically connected by conductive tapes 23. FIG. 9 illustrates only a positional relationship between solar cells, i.e., electrodes having a same polarity of the cells are arranged in a same direction. In other words, electrodes having a positive polarity of the cells are arranged face a same side, so that a same conductive strip 23 is connected to different sides of two adjacent cells, respectively. In some embodiments, the cells may also be arranged in order that the electrodes of different polarities of adjacent cells face the same side, that is, polarities of electrodes of the plurality of adjacent cells facing the same side are respectively a first polarity, a second polarity, a first polarity, and so on, and each conductive tape connects two adjacent cells on the same side.

In some embodiments, no spacing is provided between the cells, i.e., the cells may be overlapped with each other.

In some embodiments, the encapsulation layer 21 may include a first encapsulation layer covering one of a front surface and a back surface of each cell string and a second encapsulation layer covering the other of the front surface and the back surface of the cell string. Specifically, at least one of the first encapsulation layer and the second encapsulation layer may be an organic encapsulation film such as a polyvinyl butyral (PVB) adhesive film, an ethylene-vinyl acetate (EVA) adhesive film, a polyethylene octene co-elastomer (POE) adhesive film, or a polyethylene terephthalate (PET) adhesive film.

It will be appreciated that there is a division line between the first encapsulation layer and the second encapsulation layer before lamination, and there is no concept of the first encapsulation layer and the second encapsulation layer in the photovoltaic module after the lamination because the first encapsulation layer and the second encapsulation layer have formed an integral encapsulation film 21.

In some embodiments, the cover plate 22 may be a glass cover plate, a plastic cover plate, or the like having a light-transmitting function. Specifically, a surface of the cover plate 22 facing the encapsulation film 21 may be a concave-convex surface, thereby increasing the utilization rate of incident light. The cover plate 22 includes a first cover plate and a second cover plate, where the first cover plate faces the first encapsulation layer and the second cover plate faces the second encapsulation layer.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

Persons of ordinary skill in the art shall understand that the above embodiments are merely specific and exemplary embodiments for practicing the present disclosure, and in practice, various modifications may be made to these embodiments in terms of form and detail, without departing from the spirit and scope of the present disclosure. Various variations and modifications may be made by one skilled in the art without departing from the spirit and scope of the present disclosure. Accordingly, the protection scope of the present disclosure is subject to the appended claims.

## Claims

1. A tandem cell, comprising:
a bottom cell, including:
a substrate, having a front surface and a back surface that are opposite to each other, and
a semiconductor layer, disposed on the back surface of the substrate and is doped with doping ions, wherein doping concentration of the doping ions in a first part of the semiconductor layer close to the substrate is less than doping concentration of the doping ions in a second part of the semiconductor layer further away from the substrate than the first part;
an intermediate layer, disposed on a surface of the semiconductor layer away from the substrate; and
a top cell, disposed on a side of the intermediate layer away from the substrate.

2. The tandem cell of claim 1, wherein the doping concentration of the doping ions in the semiconductor layer gradually increases in a direction perpendicular to the back surface of the substrate and away from the substrate.

3. The tandem cell of claim 1 or 2, wherein the semiconductor layer includes a plurality of semiconductor films that are successively stacked in a direction perpendicular to the back surface of the substrate, the plurality of semiconductor films including at least a first semiconductor film and a second semiconductor film, the first semiconductor film being adjacent to the second semiconductor film and closer to the substrate than the second semiconductor film, and doping concentration of the second semiconductor film is greater than doping concentration of the first semiconductor film.

4. The tandem cell of claim 3, wherein the plurality of semiconductor films include adjacent semiconductor films having a same thickness or gradually increasing thicknesses.

5. The tandem cell of any of claims 1 to 4, wherein the semiconductor layer includes a first semiconductor film and a second semiconductor film stacked on a side of the first semiconductor film away from the substrate, and the second semiconductor film has a thickness larger than or equal to a thickness of the first semiconductor film.

6. The tandem cell of claim 5, wherein the first semiconductor film has the thickness in a range of 5 nm to 120 nm, and the second semiconductor film has the thickness in a range of 5 nm to 100 nm.

7. The tandem cell of any of claims 1 to 6, wherein the semiconductor layer has a total thickness in a range of 10 nm to 120 nm.

8. The tandem cell of any of claims 1 to 7, wherein doping concentration of doping ions in the semiconductor layer at a surface of the semiconductor layer away from the substrate is in a range of 1×10¹⁹ cm³ to 1× 10²¹ cm³.

9. The tandem cell of any of claims 1 to 8, wherein a material of the intermediate layer includes inorganic oxide; and
wherein the intermediate layer has a thickness in a range of 1 nm to 20 nm.

10. The tandem cell of any of claims 1 to 9, wherein the top cell includes at least one of a perovskite thin-film solar cell, a copper indium gallium selenide thin-film solar cell, a cadmium telluride thin-film solar cell, an amorphous silicon thin-film solar cell, and a group III-V thin-film solar cell.

11. The tandem cell of any of claims 1 to 10, wherein doping concentration of doping ions in the semiconductor layer at a surface of the semiconductor layer close to the substrate is in the range of 1×10¹⁹ cm³ to 5×10²⁰ cm³.

12. The tandem cell of any of claims 1 to 11, wherein the semiconductor layer includes a third semiconductor film and a fourth semiconductor film stacked on a side of the third semiconductor film away from the substrate, wherein a doping type of the third semiconductor film is different from a doping type of the fourth semiconductor film.

13. The tandem cell of claim 12, wherein the fourth semiconductor film has doping concentration in a range of 1×10¹⁸ cm³ to 1×10²¹ cm³.

14. The tandem cell of claim 12, wherein the fourth semiconductor film has a thickness in the range of 1 nm to 20 nm.

15. A photovoltaic module, comprising:
a plurality of cell strings, wherein each of the plurality of cell strings includes a plurality of tandem cells of any of claims 1 to 14 that are electrically connected;
at least one encapsulation layer, wherein each encapsulation layer is configured to cover a surface of a corresponding cell string; and
at least one cover plate, wherein each cover plate is configured to cover a surface of a corresponding encapsulation layer away from the plurality of cell strings.
